# EUROPEAN PATENT APPLICATION

(11) **EP 4 369 341 A1**
(43) Date of publication of application: **15.05.2024**
(21) Application number: 22207156.5
(22) Date of filing: 14.11.2022
(51) Int. Cl.: G11C 7/12, G11C 11/406, G11C 11/4091, G11C 11/4094

(54) **INTEGRATED DRAM CIRCUIT, METHOD FOR REFRESHING MEMORY CELLS, AND METHOD FOR PREVENTING A DATA INTEGRITY ATTACK**

(71) Applicant: ETH Zurich, 8092 Zurich (CH)
(72) Inventor: RAZAVI, Kaveh, 8006 Zürich (CH); MARAZZI, Michele, 8050 Zürich (CH)

(57) **Abstract**

The invention relates to an integrated dynamic random access memory (DRAM) circuit comprising:
- bit lines (B_{L1}, B_{L2}, B_{LN}) and word lines (W_{L1}, W_{L2}, W_{LN});
- memory cells (C₁₁, C₁₂, C_{NM}), each memory cell (C₁₁, C₁₂, CNM) being connected to one corresponding bit line (B_{L1}, B_{L2}, B_{LN}) and one corresponding word line (W_{L1}, W_{L2}, W_{LN}) and configured to store one bit in the form of an electric charge;
- a first sense amplifier (Sₐₚ) and a precharge circuit (Pᵣₑ) connected in parallel via two bit lines (B_{L1}, B_{L2});
- a second sense amplifier (Sₐₛ);
- a transmission gate circuit (Gₐ₁) connected in parallel to the first sense amplifier (Sₐₚ) via the same two bit lines (B_{L1}, B_{L2}) and being connected to the second sense amplifier (Sₐₛ), wherein the transmission gate circuit (Gₐ₁) is configured to connect the second sense amplifier (Sₐₛ) to and disconnect the second sense amplifier (Sₐₛ) from the two bit lines (B_{L1}, B_{L2}) to which the transmission gate circuit (Gₐ₁) is connected for establishing or interrupting a parallel connection of the first sense amplifier (Sₐₚ) and the second sense amplifier (Sₐₛ).

The invention also relates to a DRAM module comprising multiple subarrays containing the integrated DRAM circuit and a method for refreshing memory cells (C₁₁, C₁₂, C_{NM}) comprised in the integrated DRAM circuit.

Finally the invention relates to a method for preventing a data integrity attack in the integrated DRAM circuit with the use of the method for refreshing memory cells (C₁₁, C₁₂, C_{NM}).

## Description

### Technical domain

The present invention concerns an integrated DRAM circuit, a method for refreshing memory cells comprised in the DRAM circuit, and a method for preventing a data integrity attack in the DRAM circuit with the use of the method for refreshing memory cells.

### Related art

Dynamic RAM or DRAM (Dynamic Random Access Memory) is one of the most used memory technologies nowadays due to its high speed and great integration density, resulting in low costs per stored bit.

In DRAM memory, data bits are stored in binary form (logical zero or logical one) in memory cells, where one memory cell stores one data bit.

In DRAM, memory cells are arranged in arrays (mats) and consist of a number of intersecting row and column lines of individual transistors or memory cells. In a conventional DRAM device, each memory cell, or memory bit, consists of one transistor (also referred to as selection transistor or cell transistor) and one capacitor for storing an electric charge. A terminal of the transistor is connected to a bit line of the memory device. Another terminal of the transistor is connected to a terminal of the capacitor, and the gate terminal of the transistor is connected to one word line of the memory device. The transistor thus acts as a gate between the bit line and the capacitor.

The second terminal of the capacitor is connected to a voltage rail which carries a voltage, such as Vdd/2 or GND. Thus, when the word line for a particular memory cell is active, the cell transistor is conducting, and the capacitor is connected via the cell transistor to the bit line. The capacitor stores the electric charge that, depending on whether the capacitor is charged or discharged, represents either a logic high or a logic low value. Further technologies are known from the prior art in which the logical state of the capacitor can be represented differently, for example, DRAMs comprising true cells and corresponding anti-cells.

Typically, a microcomputer circuit selects (or activates) particular row and column lines to access selected memory cells. "Access" typically refers to reading data from or storing data to selected memory cells. Reading data from the memory cells involves the use of a sense amplifier to detect whether the voltage level stored in the memory cell represents a binary one (logic high) or a binary zero (logic low).

Memory devices are typically constructed with complementary bit lines of equal parasitic capacitance and equal resistance. Sense amplifiers are connected between the bit lines and operate to sense the differential voltage across the bit lines. Before a memory cell is selected for access, the complementary bit lines must be equilibrated. Equilibration circuits (also referred to as precharge circuits) typically short the complementary bit lines together, resulting in an equilibrate voltage equal to the voltage midpoint between the two equal capacitance and logically opposite bit lines.

Conventionally, a DRAM contains one sense amplifier for a designated group (row or column) of memory cells, which is typically one sense amplifier for two memory cells. If the voltage level stored in the memory cell represents a binary zero, one of the bit lines will increase in level, typically to a supply voltage Vdd, and the other bit line will decrease in level, typically to a ground level GND or Vss.

If the voltage level stored in the selected memory cell corresponds to a binary one, a change in the opposite direction occurs. Through this complementary operation, the sense amplifier yields a single output signal which is coupled through a read-write or row buffer to an output pin of the DRAM device.

Since the capacitors in DRAM have a natural discharge rate, memory cells must be periodically refreshed to preserve the capacitor's electric state (charged or discharged). For this, the circuitry explained before periodically reads (accesses) each memory cell and rewrites it to restore the charge on the capacitor to its original level.

The process for reading from and storing to memory cells can be standardized and is described in standards, such as in the JEDEC standards. While reading from or storing to memory cells of a specific row comprised in a bank, other memory cells of a different row comprised in the same bank are not accessible for refreshing due to the nature of the said standard and the design of DRAM, respectively. Reversely, the memory is not available for standard read or write operations in a refresh operation. This means, in particular, that a bank can only have one activated row at a time. In conclusion, it is highly disadvantageous as it adds some overhead time to the operation, e.g. reading and storing, of modern DRAM.

Improving DRAM integration density is still subject to many research and development activities. A higher integration density lowers the costs per stored bit even further and is therefore desirable for many reasons. However, there are also risks associated with the higher density, especially concerning the security of DRAM memory devices.

Data integrity attack, such as rowhammer, is a well-known security vulnerability affecting DRAM. Rowhammer, for instance, exploits the following property of DRAM: if a row, termed aggressor row, is sufficiently often accessed in a specified period of time, then a neighboring row of the aggressor row, termed victim row, may experience changes to the information it stores, i.e., bits in the victim row may flip. With increasing integration density of the DRAM due to improvements in manufacturing, future generations of DRAM may be more susceptible to Rowhammer-type attacks as it becomes more difficult to electrically isolate neighboring memory cells from one another.

In the prior art, methods for protecting against Rowhammer have been proposed which are designed to modify a memory controller accessing a DRAM. It was, e.g., proposed to double a refresh rate of the memory cells. A further proposal was to mitigate Rowhammer in software, e.g., in an operating system. These proposals in the state of the art are known to still be vulnerable to Rowhammer attacks.

It is an object of the present invention to mitigate at least some of the disadvantages associated with the sequential operation of reading from or storing to memory cells and the required refresh operation. Another object of the present invention is to provide an integrated DRAM circuit with a high resiliency against data integrity attacks.

### Short disclosure of the invention

According to a first aspect of the present invention, an integrated DRAM circuit is disclosed involving the features recited in claim 1. Further features and embodiments of the integrated DRAM circuit of the present invention are described in the dependent patent claims.

The invention relates to an integrated DRAM circuit comprising:
- bit lines and word lines;
- memory cells, each memory cell being connected to one bit line and one word line via terminals of a cell transistor and configured to store one bit in the form of an electric charge;
- a first sense amplifier and a precharge circuit connected in parallel via two bit lines;
- a second sense amplifier;
- a transmission gate circuit connected in parallel to the first sense amplifier via the same two bit lines and being connected to the second sense amplifier, wherein the transmission gate circuit being configured to connect the second sense amplifier to and disconnect the second sense amplifier from the two bit lines to which the transmission gate circuit is connected for establishing or interrupting a parallel connection of the first sense amplifier and the second sense amplifier.

By having a first and second sense amplifier in place, whereby the second sense amplifier can be connected to and disconnected from the pair of bit lines to which the first sense amplifier is connected, the invention provides inter alia the advantage that an activation request for a first word line, e.g. for refreshing, reading from or storing data to memory cells connected to the first word line, can be served in parallel to refreshing memory cells connected to a different than the one word line. This is in many aspects desirable, as the integrated DRAM circuit can be used to reduce the overhead time required for background maintenance processes, such as the memory refresh to preserve the data stored in the memory cells.

It can be noticed that the first and second amplifiers can be connected to the pair of bit lines at the same time, and thus operate at the same time. This can also significantly speed up the process for writing/reading data to/from memory cells because data can be read/written faster since both sense amplifiers can feed the voltage signal (e.g. required for storing data to memory cells) to the pair of bit lines at the same time.

In a physical implementation of the integrated DRAM circuit, one of the sense amplifiers can be reduced in size (space used on a chip area), since the first amplifier, being permanently connected to the pair of bit lines, can first latch the bit stored in a corresponding memory cell during activation of the first bit line and the second sense amplifier can take over the amplified signal for latching when connecting or when being connected in parallel. The second sense amplifier, therefore, receives a voltage signal that was amplified already amplified by the first sense amplifier or is amplified in addition by the second sense amplifier. In summary, the second sense amplifier can be reduced in size, as the first sense amplifier primarily takes over the amplification during the activation of the corresponding word line.

Reduction in size can come in concert with further advantages. The present invention also leads to a substantial reduction in power consumption. According to the prior art, a row must remain activated as long as a row activation request is served. This consumes power, as a word line is activated, and the sense amplifier constantly drive the bit lines. Because the second sense amplifier can be disconnected from the bit lines, after the logical data has been read and the data restored, the row can be deactivated and the bit lines can be precharged. The first sense amplifier can be turned off. Because the second sense amplifier is smaller in size and does not have the bit line loads, its power consumption can be much lower. Any subsequent read/write process can go to the second sense amplifier directly, which, in case of data being written, will require a new row activation before precharging it. The bit line can also not be precharged, and the row can be kept active because the major contribution of power consumption is related to the first sense amplifier. This also allows for a simpler control logic where there is no need to re-activate a row in case of write operations.

The circuits and amplifiers as set out before can directly interact with the memory cells over the bit lines or word lines respectively, as so-called primary circuitry. The said primary circuitry shall not be mistaken with other auxiliary circuits and auxiliary amplifiers that can be comprised in other parts or sections of a DRAM module, such as conventionally comprised in the read/write circuitry that can directly interact with a data bus or an auxiliary memory controller in the DRAM module. In other words, the primary circuitry shall be the first in line (bit line, word line) circuitry seen from a memory cell, and thus being the closest circuitry to a memory mat and can be comprised in the subarray.

In a first embodiment of the first aspect of the invention, the first sense amplifier and the second sense amplifier can be configurated to be activated for sensing, amplifying and latching a potential difference between the two bit lines and can be configured to be deactivated. Activation and deactivation conventionally can be done by applying a supply voltage to or removing a supply voltage from one terminal of a transistor. Sensing can mean to sense a small voltage- or potential difference (voltage or potential swing) between the pair of bit lines that are connected to (or connectable to in the case of the second sense amplifier) the sense amplifiers, whereby the small voltage or potential difference is amplified to a recognizable logic value, such that the data can be properly interpreted by a logic circuitry. The logic value can be latched (or in other words maintained) by the sense amplifiers as long as they are activated.

In a second embodiment of the first aspect of the invention, the precharge circuit can be configured to be activated for electrically charging the two bit lines, and can be configured to be deactivated. Activation and deactivation can be done similarly as set out in the first embodiment.

In a third embodiment of the first aspect of the invention, one terminal, which can be a gate terminal, of each cell transistor can be connected to one word line and configured to activate and deactivate the corresponding word line for selecting or deselecting a corresponding memory cell. Corresponding refers to the memory cell connected to the one word line. In the case of a plurality of memory cells connected to the word line, they can be activated at once.
Activation and deactivation can be done similarly as set out in the first embodiment, whereby by activating the corresponding memory cell(s) the logic value stored in the memory cell(S) is lost, as the electric charge (or lack of charge) apparent in the capacitor is being shifted to the bit line, to which the cell transistor is connected.

In a further embodiment of the first aspect of the invention, the integrated DRAM circuit can comprise a control circuit configured to selectively activate and deactivate the cell transistors, the first and second sense amplifier, the transmission gate circuit, and the precharge circuit. The control circuit can be electrically connected to the sense amplifiers and circuits for applying or removing a control voltage. The control circuit can be configured as a dedicated control block and can be comprised in a subarray or in a bank of a DRAM chip. Alternatively, the control circuit can be integrated into and combined with other auxiliary circuits comprised in a subarray, such as a row buffer. The controls circuit can aim to control the timing of activation and deactivation of the sense amplifiers and circuits upon an activation request for one word line. The control circuit can be based on a programmable logic or can implement a predefined logic. The control circuit can be destined to control a plurality of transmission gate circuits, precharge circuits and sense amplifiers, such as outlined in one other embodiment of the first aspect of the invention. However further variations as possible, based on the specific design or configuration of the DRAM chip.

In another embodiment of the first aspect of the invention, the second sense amplifier can be connected to a pair of secondary bit lines for providing data to or receiving data from a column selector connected to the pair of secondary bit lines. The pair of secondary bit lines can be necessary as the transmission gate circuit can be configured to isolate the second sense amplifier from the bit lines to which the first sense amplifier and the precharge circuit is connected. The secondary bit lines can act as data ports connected to the column selector, which can be comprised in a row buffer of one cell array. The column selector selects one of the secondary bit lines, such that a row buffer or data buffer can read out the bit latched in the second sense amplifier. The secondary bit lines can be allocated to (being part of) the integrated DRAM circuit, however the column selector and row buffer may not be part of the integrated DRAM circuit and can be considered as auxiliary circuitry and can be allocated to the input-output path of the DRAM.

In a further embodiment of the first aspect of the invention, the integrated DRAM circuit can comprise:
- a plurality of bit lines, a plurality of word lines, and a plurality of memory cells, each being connected to one bit line and one word line and arranged in an array structure having multiple rows and columns;
- a plurality of precharge circuits, first sense amplifiers, second sense amplifiers, and transmission gate circuits, wherein each column of the array structure comprises one first sense amplifier, one precharge circuit, one transmission gate circuit, and one second sense amplifier, wherein each one of the second sense amplifiers being connectable to two bit lines of a column through the transmission gate circuit. The bit lines must not necessarily correspond to the bit lines in one specific subarray. There are configurations known from the prior art, where the sense amplifiers and precharge circuits are shared by two subarrays, whereby one bit line of each subarray is connected to one first sense amplifier and one precharge circuit, respectively. The transmission gate circuit and the second sense amplifier can be built upon this structure and simply added to the first sense amplifier and precharge circuit known from the prior art.

In a brief summary, one subarray of a DRAM is or can be constructed in this embodiment by allocating one precharge circuit, one first sense amplifier, one transmission gate, and one second sense amplifier to each column of the array, whereby the array or subarray respectively can have multiple rows and columns. The memory cells connected to the word line of one row can be simultaneously refreshed by the parallel activation of sense amplifiers, transmission gate circuits comprised in each column and with respect to the related word line the memory cells are connected to. Parallel activation refers specifically to the columns and not necessarily to the parallel activation of the first and second sense amplifier comprised in one column. As outlined in one of the embodiments before, the control circuit can be configured to control the timing of the activation and deactivation of individual sense amplifiers and circuits. Since the second sense amplifiers can be decoupled from the bit lines and latches the logic values of the memory cells independently from the state (activation) of first sense amplifiers, can the first sense amplifiers also be used to write the data latched to the second sense amplifier to a different row (instead of just refreshing the row). Alternatively, can the first sense amplifiers be used to refresh a row and copy the logic values obtained during the refresh to one different row. In both cases, the first sense amplifiers need to stay activated to maintain the latched logic values.

Some or all embodiments of the first aspect of the invention can be combined when it is useful from a technical standpoint.

According to a second aspect of the present invention, a DRAM module is disclosed, whereby the DRAM module can comprise a plurality of DRAM chips, wherein each DRAM chip comprises a plurality of banks with a plurality of subarrays, such as disclosed in one embodiment of the first aspect of the invention wherein, each subarray can comprise the integrated DRAM circuit as disclosed in one embodiment or from a combination of embodiments as disclosed with respect to the first aspect of the invention.

By implementing the integrated DRAM circuit in a DRAM module, the said module is equipped with the functionality and entails the advantages as discussed with respect to the first aspect of the invention, but on a larger scale, since DRAM modules comprise a magnitude of memory cells and corresponding subarrays. The advantage, in particular with respect to the reduction of overhead time for maintenance activities (refreshing), is nearly multiple by the factor of banks comprised in the DRAM module, as only one word line can be activated at a time in a bank.

According to a third aspect of the present invention, a method for refreshing memory cells is disclosed. The method can be used for refreshing memory cells connected to a second word line, while processing or serving an activation request for a first word line, wherein the memory cells and the word lines being comprised in the integrated DRAM circuit of one embodiment or a combination of embodiments as disclosed in the first aspect of the invention.

The method can comprise the steps of:
- receiving a request for activation of the first word line from a memory controller external to the integrated DRAM circuit;
- activating the first word line, the transmission gate circuit, and the second sense amplifier for latching the bit stored in the memory cell connected to the first word line into the second sense amplifier;
- deactivating the first word line and the transmission gate circuit;
- precharging the bit lines by sequentially activating and deactivating the precharge circuit;
- activating the second word line being different from the first word line, and the first sense amplifier for latching the bit stored in the memory cell connected to the second word line into the first sense amplifier;
- sequentially deactivating the second word line and the first sense amplifier for storing the bit latched in the first sense amplifier into the corresponding memory cell;
- activating the first word line, the transmission gate circuit; and
- sequentially deactivating the first word line, the transmission gate circuit and the second sense amplifier for storing the bit latched in the second sense amplifier into the corresponding memory cell.

In some steps, the activation of the second sense amplifier is mentioned only. That does not exclude that the first amplifier can be already active while activating the first amplifier or can be activated simultaneously with the second sense amplifier.

As indicated, the method can be used for refreshing memory cells connected to the second word line while processing or serving an activation request for the first word line. The method can be used to significantly reduce the overhead time for memory maintenance (refresh) that is conventionally performed as a background activity. A DRAM module can benefit from the method significantly and the speed for reading from or storing data to memory cells can be improved, as the access to one word line may not be blocked for memory maintenance activities. In addition, the method is lean and can rapidly be processed with the help of the integrated DRAM circuit as disclosed in the first aspect of the invention, within a fraction of a second.

In a first embodiment of the third aspect of the invention, the steps can be performed in the sequence exactly as set out hereinbefore. However, this does not exclude any deviation from the sequence when it is technically useful.

In a second embodiment of the third aspect of the invention, the method can further comprise the step of precharging the bit lines by sequentially activating and deactivating the precharge circuit before activating one word line. The word line can be the first word line for which an activation request was received and/or the second word line for which it is intended to refresh memory cells connected thereto. Before activating the first word line, the bit lines might be precharged already, as the precharge circuit might already be activated. In this specific case the activation of the recharge circuit is not required and the only action to be taken can be the deactivation of the precharge circuit.

In a third embodiment of the third aspect of the invention, the method can comprise the step of overwriting the bit or logic value latched in the second sense amplifier for updating the memory cell connected to the first word line with data received from a row buffer. As disclosed herein before, he row buffer can be a means external to the integrated DRAM circuit. The term overwriting means to store a different logic value into the second sense amplifier, which can then be stored into the memory cell connected to the first word line by deactivating the first word line. The activation request for the first word line can be completed by deactivation the first word line.

In a further embodiment of the third aspect of the invention, the steps can be performed within one row active time "tRAS" in accordance with the JEDEC standard JESD79-4D or JESD79-5B, respectively. This can be exactly the time that is reserved by a memory controller or a different higher-level controller for serving an activation request. By doing so, there is no need for reserving a different time slot for performing the method. The method can be easily built upon and be integrated into the timing as defined in the cited standards. Typically and according to the standards, as defined, a row activation time accounts for 32ns. This activation time shall not be undercut but can be prolonged when the memory controller requires it.

In another embodiment of the third aspect of the invention, the method can be used or performed alternatively or in addition to refreshing operations as defined in the said standard. Both alternatives can be useful. For the first alternative, the background activity for refreshing memory cells can be performed less regularly, freeing the capacity for different tasks in the memory. For the second alternative, the methods can be used in parallel with the aim to refresh memory cells more regularly, which can lead to an improved data integrity since the risk of losing data is significantly reduced by refreshing more regularly. Implementing other technologies into the DRAM, such as error correction code (ECC), can be omitted.

It needs to be noted that all embodiments of the third aspect can be combined when it is technically useful.

According to a fourth aspect of the present invention, a method for preventing a data integrity attack is disclosed.

The method can be used for preventing a data integrity attack in an integrated DRAM circuit according to one embodiment or a combination of embodiments of the first aspect of the invention or in a DRAM module of the second aspect of the invention.

The method can comprise the steps of:
- identifying a request for activation of the first word line;
- refreshing memory cells connected to a different than the first word line by sequentially applying the method for refreshing memory cells as disclosed in one or a combination of embodiments according to the third aspect of the invention.

The data integrity attack can be in the form and may have the effect of a rowhammer attack. By refreshing memory cells with the use of the method for refreshing memory cells, the stored data is maintained. Successive requests for a word line activation thus may not affect the data integrity of memory cells connected to a different word line if the memory cells are refreshed regularly. This can be done, for example, by successively refreshing all memory cells in a subarray or array.

In one embodiment of the fourth aspect of the invention, the different than the first word line, can be a word line comprised in a row directly adjacent to the row of the first word line or can be selected for refreshing memory cells based on a probability for a data integrity threat to memory cells connected to the said different word line, due to an activation of the first word line.

The probability for the integrity threat can depend on a physical distance of the said different word line to the first word line, as electric and/or magnetic fields generated by the activation of the first word line and the corresponding row of memory cells respectively, can have less impact to memory cells far distant to the activated first word line (the activated row). The data integrity threat can be understood as an attack that attempts to corrupt data comprised in memory cells not connected to the activated first word line. The attack can happen intentionally in the course of a cyber-attack or might be caused accidentally by a malfunction or during normal operation under of a control circuit comprised in the DRAM memory or a higher-level memory controller.

### Short description of the drawings

Exemplar embodiments of the invention are disclosed in the description and illustrated by the drawings in which:
Figure 1: illustrates a simplified memory cell array schematically, according to the state of the art.
Figure 2: illustrates a simplified subarray schematically, according to the state of the art.
Figure 3: illustrates a simplified memory cell array schematically, according to the present invention.
Figure 4: illustrates schematically a precharge circuit, a sense amplifier circuit, and a transmission gate circuit used in the memory cell array, according to the present invention.
Figure 5: illustrates schematically a process for refreshing memory cells comprised in different rows of the memory cell array according to the present invention.
Figure 6: illustrates the timing and states of the circuitry used for the present invention.
Figure 7: illustrates schematically a control circuit used for controlling the process of refreshing memory cells with the circuitry used for the present invention.
Figure 8: illustrates schematically a probability for a data integrity threat depending on the activation of a row.

### Examples of embodiments of the present invention

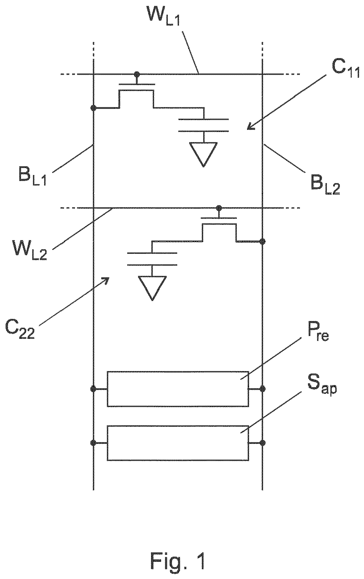

Fig.1 illustrates a simplified memory cell array according to the prior art. Two memory cells C₁₁, C₂₂ are illustrated. Each memory cell C₁₁, C₂₂ comprises a cell transistor with three terminals. The gate terminal of each cell transistor is connected to one different word line, being word line W_{L1} and word line W_{L2}. The source terminal of each cell transistor is connected to one different bit line, being bit line B_{L1} and B_{L2}. As shown in the figure, each memory cell C₁₁, C₂₂ comprises one capacitor connected with the first terminal to the drain terminal of the corresponding cell transistor and the second terminal to the ground potential GND.

One precharge circuit Pᵣₑ is connected to the two bit lines B_{L1},B_{L2}. One sense amplifier Sₐₚ is connected in parallel to the precharge circuit Pᵣₑ via the two bit lines B_{L1}, B_{L2}. Each word line W_{L1}, W_{L2} can be activated by selectively applying a supply voltage to one of the word lines W_{L1}, W_{L2}. Correspondingly each word line W_{L1}, W_{L2} can be deactivated by removing the supply voltage V_{dd}, and connecting the word line W_{L1}, W_{L2} to the ground potential or to a voltage slightly lower than ground potential (e.g. Vss).

By activating one word line W_{L1}, W_{L2}, the gate of a corresponding one cell transistor is set to the voltage of the corresponding word line W_{L1}, W_{L2}. The capacitor can be charged by applying a voltage to the corresponding one of the bit line B_{L1}, B_{L2}, to which the source terminal of the cell transistor is connected. In reverse, the capacitor can be discharged by decreasing the voltage from the corresponding bit line B_{L1}, B_{L2} to which the source terminal of the cell transistor is connected. By activating one word line W_{L1}, W_{L2}, the electric charge or lack of electric charge apparent in the capacitor is destroyed.

As already outlined in one of the paragraphs before, needs the memory cells C₁₁, C₂₂ to be refreshed periodically to maintain the electric charge stored (or the absence of the electric charge) in the related capacitor of the memory cells C₁₁, C₂₂. A refresh is performed by charging the two bit lines B_{L1}, B_{L2} with the use of the precharge circuit Pᵣₑ, by a voltage that corresponds approximately to one-half of the supply voltage. Once the pair of bit lines B_{L1}, B_{L2} reaches that voltage level, the precharge cicuit Pᵣₑ is deactivated and the bit lines B_{L1}, B_{L2} remain at the voltage level as applied "precharged". Once the precharge circuit Pᵣₑ is deactivated, only one of the word lines W_{L1}, W_{L2} is activated. By doing so, the cell transistor connected to the activated word line W_{L1}, W_{L2}, enters into a conductive state, such that the electric charge apparent in the corresponding capacitor slightly charges the bit line B_{L1}, B_{L2} to which the cell transistor is connected to a slightly higher potential, than the other bit line B_{L1}, B_{L2}. In reverse, suppose the capacitor is uncharged (lack of charge) the corresponding bit line B_{L1}, B_{L2} would be lowered to a slightly lower potential than the other bit line B_{L1}, B_{L2}, as a current flows into the cell capacitor.

By activating the sense amplifier Sₐₚ, it reinforces the potential difference, since one of the bit lines B_{L1}, B_{L2} was brought by the charge or lack of charge to a slightly higher or lower potential respectively, than the other bit line B_{L1}, B_{L2} to which the memory cell transistor is not connected. The sense amplifier Sₐₚ amplifies the potential difference until one of the bit lines B_{L1}, B_{L2} holds a higher voltage than the other bit line B_{L1}, B_{L2}, depending on the charge or lack of charge of the capacitor of the memory cell C₁₁, C₂₂. Usually, one of the bit lines B_{L1}, B_{L2} is brought by the sense amplifier Sₐₚ to the supply voltage level, whereas the other bit line B_{L1}, B_{L2} is brought the ground potential or a slightly lower potential. The sense amplifier Sₐₚ maintains "latches" the potential difference stable until it gets deactivated, after the deactivation of the activated word line W_{L1}, W_{L2}.

The memory cell C₁₁, C₂₂ is refreshed by deactivating the activated word line W_{L1}, W_{L2} since the capacitor of the memory cell C₁₁, C₂₂ was brought to the potential of the bit line B_{L1}, B_{L2} to which the source terminal of the cell transistor is connected. The capacitor of the memory cells C₁₁, C₂₂ maintains the charge until a further refresh is required, usually within some milliseconds.

Reading from a memory cell C₁₁, C₂₂ takes benefit of the same process as outlined herein before. Once the sense amplifier Sₐₚ is latched, a read/write-circuity connected to the pair of bit lines B_{L1}, B_{L2} takes the voltage signal from the one bit line B_{L1}, B_{L2} as it corresponds to a logical one (in case the bit line B_{L1}, B_{L2} carries the supply voltage) or logical zero (in case the bit line B_{L1}, B_{L2} carries the ground potential or a slightly lower potential). Also, writing to memory cells C₁₁, C₂₂ (storing data to) takes benefit of the same process. After the sense amplifier Sₐₚ is latched, a polarity (that can correspond to a logical one or a logical zero) is applied to the sense amplifier Sₐₚ, by the read/write-circuity. By doing so, the sense amplifier Sₐₚ is forced to latch to the new polarity (or the same polarity of the same logic value is rewritten). The capacitor of the memory cell C₁₁, C₂₂ activated by the activation of the word line W_{L1}, W_{L2} will be charged or discharged respectively with the new signal apparent in the sense amplifier Sₐₚ and by subsequently deactivating the activated word line W_{L1}, W_{L2}. The new polarity is stored (written to the memory cell C₁₁, C₂₂).

The process as outlined for one of the memory cells C₁₁, C₂₂, was used for refreshing, reading from or writing to one of the memory cells C₁₁, C₂₂., for example the memory cell C₁₁. However, the same process is also applied to the other memory cells, for instance the memory cell C₂₂.

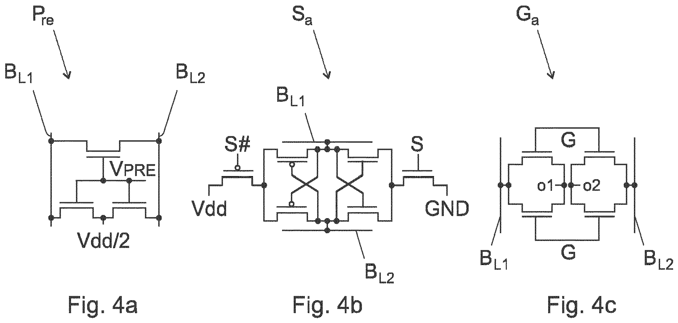

The circuitry of the sense amplifier Sₐ and the precharge circuit Pᵣₑ is schematically illustrated in Figs. 4a and 4b, whereas Fig. 4a illustrates an example of the precharge circuit Pᵣₑ. The upper transistor of the precharge circuit Pᵣₑ is connected with its terminals to two bit lines B_{L1}, B_{L2}. A pair of transistors form a series connection, with one tapping point at the terminal connection point of the in series connected transistors. One terminal of each transistor is also connected to the two bit lines. The gates of the transistors are interconnected to form a central connection point V_{PRE}. The tapping point is connected to one half of the supply voltage V_{dd}/2 and the central connection point acts as an input terminal. The precharge circuit is activated by applying the supply voltage to the central connection point V_{PRE}. By doing so, the transistor enters into the conductive state, and the half of the supply voltage V_{DD}/2 is connected to the pair of bit lines B_{L1}, B_{L2} for precharing. The precharge circuit Pᵣₑ is deactivated by removing the supply voltage from the central connection point V_{PRE}, since the transistors enter into the non-conductive stage.

Fig. 4b illustrates an example of the sense amplifier Sₐ schematically. In the center two pairs of in series connected transistors can be noticed, wherein one of the in series connected transistors is configured as an active low transistor. Each series connection of the pair of series connections comprises a tapping point, to which one bit line B_{L1}, B_{L2} is connected. The gates of the in series connected transistors are connected to the tapping point of the other in series connected transistors, forming a cross connected gate connection of the pair. The other terminals of the in series connected transistors are connected together. The sense amplifier Sₐ also comprises two activation transistors, whereas one is configurated as active low transistor. By applying the supply voltage (or a reverse voltage to the active low transistor) to the gates S, S# of the activation transistors, the sense amplifier Sₐₚ is activated and amplifies the potential difference apparent between the bit lines B_{L1}, B_{L2} until one bit line B_{L1}, B_{L2} reached the supply voltage V_{dd} connected to the terminal of one activation transistor or the ground potential GND connected to the terminals of the second activation transistor respectively. Again, the final voltage set to the bit line B_{L1}, B_{L2} depends on the voltage/potential difference apparent between the two bit lines B_{L1}, B_{L2} before the activation transistors are activated. The final voltage is maintained as long as the activation transistors are activated. However, the polarity of the final voltage can be reversed by applying a voltage with a reversed polarity to the bit lines B_{L1}, B_{L2}, whereby the sense amplifier Sₐ latches this voltage. This is required, as explained before, for storing data into the memory cells.

The circuits of the sense amplifier Sₐ and the precharge circuit Pᵣₑ are illustrated for the sake of understanding the invention, but can be replaced by equivalent functioning circuits when technically useful.

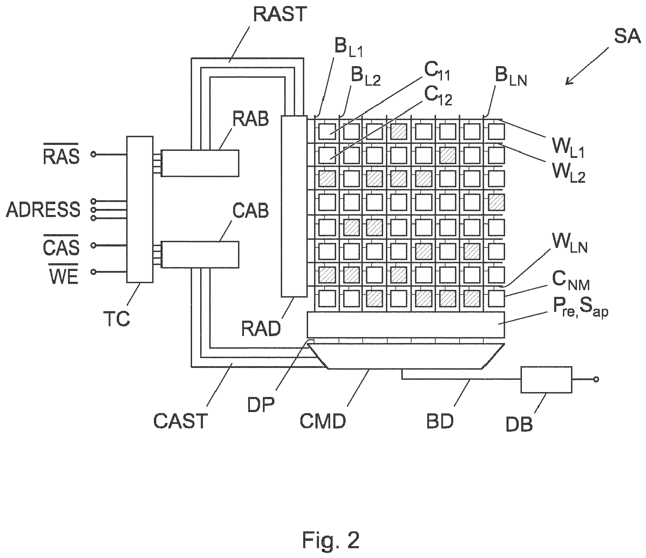

Fig. 2 illustrates a subarray SA schematically, whereby the subarray SA contains a plurality of memory cell arrays as of Fig. 1, arranged in an array of the size eight by eight and therefore being capable of storing 64 bits of data. It must be noted, that compared to commercially available DRAM devices, the structure is highly simplified. However, for the sake of explanation is a reasonable simplification.

The memory cells C₁₁, C₁₂, C_{NM} are arranged in rows and columns, whereby the memory cells C₁₁, C₁₂, C_{NM} connected to a specific word line W_{L1}, W_{L2}, W_{LN} can be activated for refreshing, reading from, or storing data to by the activation of one word line W_{L1}, W_{L2}, W_{LN}. Each column comprises one dedicated precharge circuit and one dedicated sense amplifier connected to one pair of bit lines B_{L1}, B_{L2}, B_{LN}, and illustrated to be located in the block Pᵣₑ,Sₐₚ. The memory cells C₁₁, C₁₂, C_{NM} highlighted with the diagonal stripes shall indicate to contain data "bit". As already outlined in one of the paragraphs before but not illustrated in the figure, a subarray can comprise multiple memory cell arrays (maps). It can be beneficial when two directly adjacent memory cell arrays share one dedicated precharge circuit and one dedicated sense amplifier. For this purpose, form one bit line of each of the two said memory cell array a pair of bit lines, connected to the one dedicated precharge circuit and to the one dedicated sense amplifier.

Suppose the memory cell C₁₁ needs to be refreshed, the precharge circuit allocated to the first column is sequentially activated and deactivated for charging the first two bit lines B_{L1}, B_{L2} of the first column. Subsequentially the first word line W_{L1} is activated. Shortly after the activation of (or while activating) the first word line W_{L1}, the sense amplifier allocated to first column is activated to amplify and latch the potential difference apparent between the first two bit lines B_{L1}, B_{L2} of the first column. By deactivating the first word line W_{L1} the by the sense amplifier latched signal is stored into the memory cell C₁₁. As mentioned in the paragraph before, there is a plurality of sense amplifiers and precharge circuits comprised in the block Pᵣₑ,Sₐₚ, and they are operating in parallel, meaning that one row can be refreshed at once when the corresponding word line W_{L1}, W_{L2}, W_{LN} of a row is enabled.

For reading from a memory cell and outputting the logic value to an address bus (not illustrated), the following steps need to be taken with the support of the auxiliary circuits that operate in harmony but in a sequential manner. The timing and control circuit TC comprises multiple pins, such as the row address strobe enable R̅A̅S̅, the column address strobe enable C̅A̅S̅, the write enable W̅E̅, and the address pins ADRESS. By the bit address, apparent as binary values at the related address pins ADRESS one single memory cell is addressable. The row address buffer RAB connected to the row address decoder RAD via the row address bus strobe RAST can be activated by the row address strobe enable R̅A̅S̅. The same applies to the column address buffer CAB connected to the column multiplexer/demultiplexer CMD (which includes the read-write or row buffer) over the column address strobe CAST, which can be enabled by the column address strobe enable C̅A̅S̅. A read cycle includes, that the bit lines B_{L1}, B_{L2}, B_{LN} are precharged by activating the precharge circuit in an initial state, and an external memory controller applies the row address to the address pins ADRESS and the row address strobe R̅A̅S̅ is enabled. As soon as this happens, the read cycle is triggered. The precharge circuits are disabled and the bit lines B_{L1}, B_{L2}, B_{LN} remain precharged. The row address is decoded by the row address decoder RAD and the corresponding word line W_{L1}, W_{L2}, W_{LN} is activated. The entire row is latched into the sense amplifiers, including the logic value of one memory cell that is subjected to be outputted. Subsequently, the column address is presented at the address pins ADRESS by the external memory controller, and the column address strobe CAST is enabled by activating the column address strobe enable C̅A̅S̅. The column address is latched into the column address buffer CAB. The column address is used by the column multiplexer/demultiplexer CMD to select the logical value "bit" (out of the eight values latched by the sense amplifiers) to be outputted. The selected logical value is subsequently directed to the data buffer DB. The row address strobe RAST is subsequentially disabled and the logical value becomes available at the external output pin (the pin connected to the data buffer on the right). The final stage is to refresh the rows by using the voltage signals latched into the sense amplifiers by sequentially deactivating the column address strobe CAST and the row address strobe RAST. It can be noticed that obtaining one logic value from one memory cell comprises many steps to be taken, including an appropriate timing by activating and deactivating the auxiliary circuits. Storing one logic value to one memory cell C₁₁, C₁₂, C_{NM} comprises the same steps to be take, but the value latched in one of the sense amplifiers is overwritten by activating the write enable pin W̅E̅ and taking the logic value that is apparent at the external output pin before the column address strobe CAST and the row address strobe RAST are sequentially disabled.

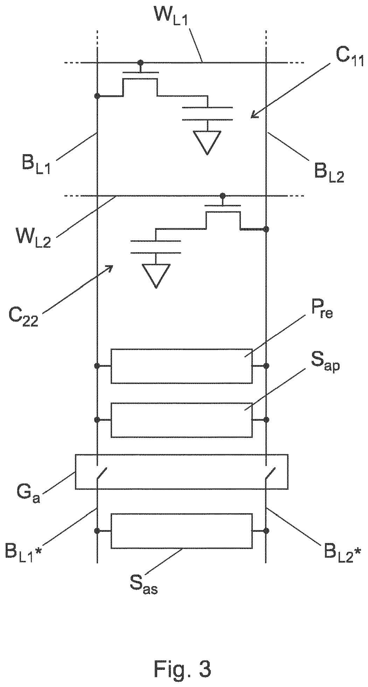

Fig.3 illustrates one memory cell array according to the present invention. It must be noted that for simplicity's sake, only one simplified memory cell array is illustrated. In a real implementation, multiple memory cells C₁₁, C₁₂, including word lines W_{L1}, W_{L2} and bit lines B_{L1}, B_{L2} are arranged side by side in a row and one after the other in a column.

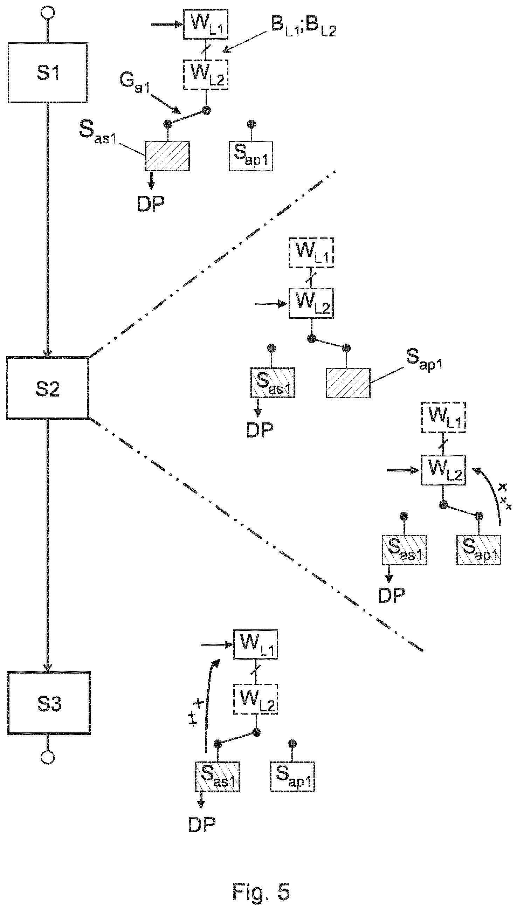

The memory cell array deviates from the memory cell array as disclosed in Fig. 1, by the addition of the transmission gate circuit Gₐ, the second sense amplifier Sₐₛ and the pair of secondary bit lines B_{L1*}, B_{L2*}. The transmission gate circuit Gₐ functions as a switch between the pair of bit lines B_{L1}, B_{L2} and the pair of secondary bit lines B_{L1*}, B_{L2*}. The transmission gate circuit Gₐ can thus couple the pair of secondary bit lines B_{L1*}, B_{L2*} to and decouple the secondary bit lines B_{L1*}, B_{L2*} from the pair of bit lines B_{L1}, B_{L2}. By doing so, the second sense amplifier Sₐₛ is coupled to or decoupled from the pair of bit lines B_{L1}, B_{L2}. The functioning of second sense amplifier Sₐₛ corresponds to the functioning of the first sense amplifier Sₐₚ, and contains the circuitry as explained for Fig. 4b. The memory cell array as being used for the subarray SA of Fig. 2, can be replaced by memory cell array as disclosed for Fig. 3, which provides further advantages, which will become apparent in connection with the description of Fig. 5.

Fig. 4c illustrates the implementation of the transmission gate circuit Gₐ. In total four transistors are used, whereby a pair of transistors are connected in parallel by interconnecting their drain and source terminals. One interconnection point of each pair is connected to one bit line B_{L1}, B_{L2}, and the remaining interconnection point provides output/input terminals o1, o2, to which the second sense amplifier of Fig. 3 can be connected over the secondary bit lines. The gate terminals of one pair are connected to the gate terminals of the second pair. By applying a supply voltage to the gate terminals G, the first output/input terminal o1 gets connected through the first transistor pair to the first bit line B_{L1}, and the second output/input terminal o2 gets connected through the second transistor pair to the second bit line B_{L2}. Suppose the pair of the secondary bit lines are connected to the output/input terminals o1, o2, can the second sense amplifier releasable connected to the first pair of bit lines via the transmission gate circuit Gₐ.

Fig. 5 illustrates a process or sequence schematically for refreshing memory cells comprised in different rows of the memory cell array of Fig. 3 or the subarray of Fig. 2, when combined with the memory cell array of Fig. 2.

The process or sequence starts from the top and comprises in summary three steps, whereby step 2 is divided into a plural of subsequent steps. Suppose the DRAM receives a row activation request from a memory controller or other higher level controller external to the memory cell array or the subarray.

The labelled rectangles shall illustrate a logical representation of the states of the circuitry as illustrated in Fig. 3. W_{L1} corresponds to the first word line for which an activation request was received, B_{L1};B_{L2} to the first and second bit line connected to the first sense amplifier Sₐₚ₁, the transmission gate circuit Gₐ₁ and connectable via the transmission gate circuit Gₐ₁to the second sense amplifier Sₐₛ₁. W_{L2} corresponds to the second world line W_{L2}, which is subjected to be refreshed (in particular, the memory cell connected thereto).

The line positioned between the terminals of second word line W_{L2} and the first word line W_{L1} shall indicate the state the transmission gate circuit Gₐ₁. The arrow pointing to the rectangle shall illustrate which of the word lines W_{L1}, W_{L2} is activated during the corresponding step.

In step 1 the second sense amplifier Sₐₛ₁ latches the logical values from the requested row by activating the first word line W_{L1}. The latching mechanism is first started by the first sense amplifier Sₐₚ₁ and quickly latched by the said sense amplifier Sₐₚ₁. The diagonal stripes to the right shall indicate that the logical value is latching into the second sense amplifier Sₐₛ₁.

To correctly multiplex the bit line B_{L1};B_{L2}, the transmission gate circuit Gₐ₁ is required. This transmission gate circuit Gₐ₁ prevents the logical value held by the second sense amplifier Sₐₛ₁ from being corrupted by the refresh mechanism of the first sense amplifier Sₐₚ₁ when the said first sense amplifier Sₐₚ₁ is activated in a subsequent step. Therefore, before activating the second word line W_{L2}, three events are necessary, namely deactivating the transmission gate circuit Gₐ₁, the first sense amplifier Sₐₚ₁, and restoring the bit line B_{L1};B_{L2} to the reference voltage "precharging". The logic value is maintained (latched) by the second sense amplifier Sₐₛ₁, as indicated by the diagonal stipes to the left.

In step 2 the first sense amplifier Sₐₚ₁ performs a parallel refresh to the second word line W_{L2} (the memory cell connected thereto). First, the second word line W_{L2} is activated, then the potential difference apparent between the two bit lines B_{L1};B_{L2} is amplified (diagonal stripes to the left) and the logical value stored in the memory cell connected to the second word line W_{L2} is latched by into the first sense amplifier Sₐₚ₁ (diagonal stripes to the right). By deactivating the second word line W_{L2}, the memory cell is refreshed (indicated by an arrow and the crosses).

In the next step, step 3, the second sense amplifier Sₐₛ₁ will use the logic value stored by the second sense amplifier Sₐₛ₁ to charge the memory cell connected to the first word line W_{L1}. Before Step 3 can be started, the first sense amplifier Sₐₚ₁ needs to be deactivated, and the bit line B_{L1}; B_{L2} needs to be precharged. This precharge is required because the second sense amplifier Sₐₛ₁ might lose the latched value due to the high-charge parasitics of the bit lines B_{L1}; B_{L2}.

In step, the second sense amplifier Sₐₛ₁ recharges the memory cell connected to the first word line W_{L1} with the logic value latched. First, the transmission gate circuit Gₐ₁ is activated for connecting the second sense amplifier Sₐₛ₁ to the bit lines B_{L1};B_{L2}. Then, the first sense amplifier Sₐₚ₁ and subsequently the second sense amplifier Sₐₛ₁ are activated, such that the second sense amplifier Sₐₛ₁ assist in the refresh of memory cell. The process is completed by deactivating the row, by deactivating the first word line W_{L1}.

The data port DP can correspond to one of the secondary bit lines of Fig. 3 connected at one end to a column selector for reading from or storing logic values in the memory cell(s).

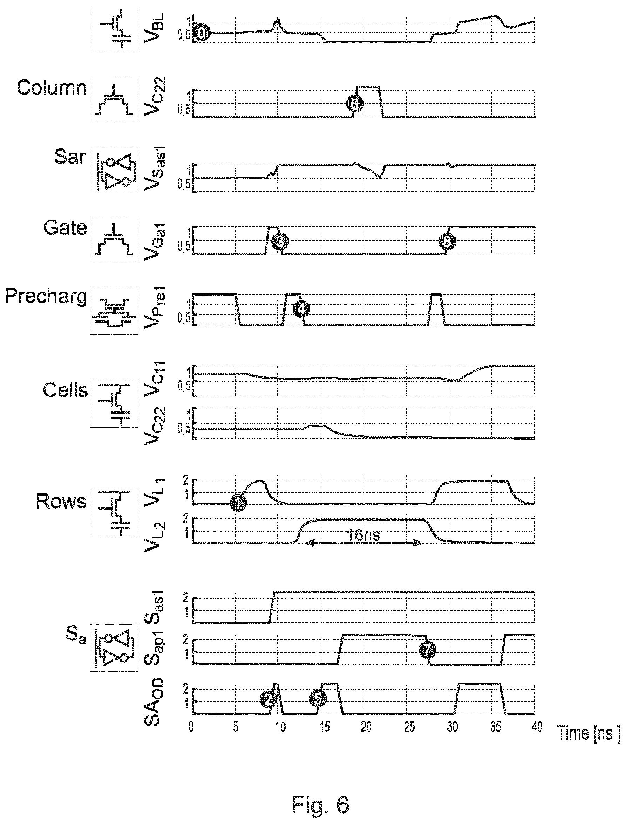

Fig. 6 illustrates the timing and states of the circuitry used for the present invention in a signal diagram. In particular, the timing is illustrated for the memory cell array of Fig. 3. It can be noticed that states correspond to the logical timing as discussed in respect to Fig. 5. The voltage signals can be noticed and determined on the axis of ordinate, whereby the axis of abscissa illustrates the timing in nano seconds. The voltage signal ranges between zero volts (GND or Vₛₛ) up to 2.5V, which can correspond to the overall power supply level.

Initially, the bit lines are precharged (V_{BL}, 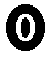 ). An activation request for the activation of the first word line is received, and the corresponding word line is raised (V_{L1}, 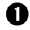 ). After the charge sharing operation of the bit lines, the first sense amplifier supports the second sense amplifier latching the memory cell's value (SA_{OD}, 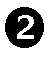 ). After the second sense amplifier has started the latching operation, the transmission gate circuit is deactivated to disconnect the second sense amplifier from the bit lines (V_{Ga1} 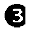 ). At this point, the bit lines are returned to the reference voltage via the precharge circuit (V_{Pre1}, 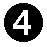 ). The second word line is activated, and the first sense amplifier performs a normal refresh operation (SA_{OD}, 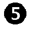 ; Sₐₚ₁, 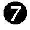 ). Parallel to the refresh of the memory cell connected to the second word line, a read operation occurs (V_{C22}, 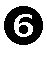 ) by reading from the first sense amplifier. Once the memory cell connected to the second word line has been refreshed, the first sense amplifier is deactivated (Sₐₚ₁, 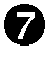 ). After a brief precharge operation, the transmission gate circuit is activated (V_{Ga1}, 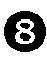 ), and the memory cell connected to the first word line is refreshed by the combined operation of the first and second sense amplifier.

Even though the method and process of Figs. 5 and 6 were exemplarily explained for two memory cells, it is self-evident that it also applies to multiple memory cells connected to the two word lines. The sense amplifiers, precharge circuits, and transmission gate circuits comprised in a column operate in parallel.

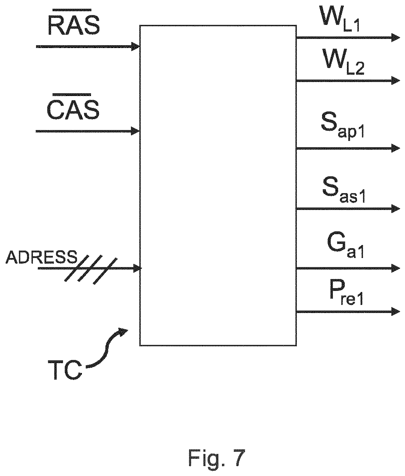

Fig. 7 illustrates schematically a control circuit used for controlling the process of refreshing memory cells with the circuitry used for the present invention, in particular, the memory cell array as disclosed in Fig. 3. The control circuit is a part of the timing and control circuit as illustrated in Fig. 2 and is configured to implement the process and the timing as disclosed in Figs. 5 and 6. As it can be noticed, the control circuit TC is configured with multiple input ports, that correspond to the input ports of the timing and control circuit of Fig. 2. The output ports or control ports are connected to and configured to activate or deactivate the word lines W_{L1}, W_{L2}, the first and second sense amplifiers Sₐₚ₁, Sₐₛ₁, the transmission gate circuit Gₐ₁, and the precharge circuit Pᵣₑ₁. The activation and deactivation are in accordance with the sequence as explained in Fig. 5. The voltage signals correspond to the signals and the timing as illustrated in Fig. 6. In a real implementation, the control circuit TC might be configured with much more output ports, as multiple word lines, sense amplifiers, etc. need to be activated and deactivated for refreshing, reading from or storing to a plurality of memory cells connected to the word lines of a subarray. Each subarray can comprise one individual control circuit TC. However, the control circuit can be implemented alternatively as a single entity comprised in a subarray.

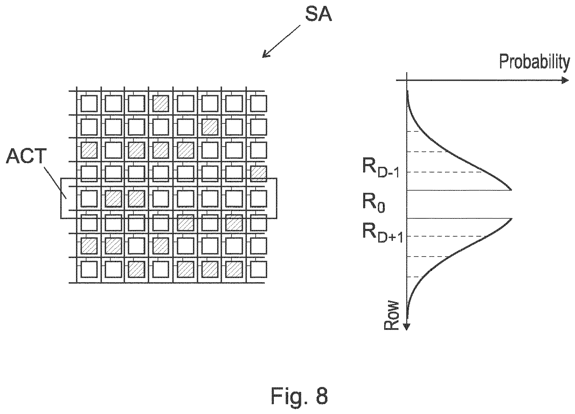

Fig. 8 illustrates schematically a probability curve for a data integrity threat depending on the recurring activation of one row. On the left, the array of memory cells is illustrated, which corresponds to the array (map) as of Fig. 2. The sense amplifiers (first and second), the transmission gate, and the precharge circuit as of Fig. 3 is omitted, due to the sake of simplicity. However it is apparent that they need to be present for processing the method as explained for Figs. 5 and 6.

Data integrity threats, such as rowhammer attacks, focus on serving recurring activation requests to one specific row. Due to recurring activation, directly adjacent memory cells are more likely to face data integrity issues. This is illustrated on the right, where a probability curve (not true to scale) is illustrated. The probability curve contains a gap in the center R₀, because the row that is recurringly activated is normally not subjected to a data integrity threat, as the memory cells are recurringly refreshed by the activation of the corresponding word line. However, neighboring cells (including cells directly adjacent to the activated row) are more likely to face data integrity issues. As a rule of thumb, the closer the memory cells connected to a neighboring word line are to the recurringly activated word line of a row, the more likely it is that they face data integrity issues. R_{D1} and R_{D+1} denote the probability of the data integrity issue for the row directly adjacent to the recurringly activated word line ACT. The process for refreshing memory cells, as outlined with respect to Figs. 5 and 6 are used to refresh the memory cells connected to the word lines directly adjacent to the recurringly activated row (word line), to prevent data integrity issues. This means that the said process is used to refresh, reading from or storing data to memory cells connected to the recurringly activated worldline ACT, whereas memory cells adjacent to the recurringly activated word line ACT are refreshed in parallel while the activation request is served.

Of course, since only one transmission gate circuit for each column is suggested, only the memory cells connected to one bit line can be refreshed at the time the activation request is served. Therefore, a logic is foreseen to refresh the memory cells connected to a different than the recurringly activated word line ACT, to prevent data integrity issues or threats.

This logic comprises refreshing memory cells in each row, by refreshing one row after the other upon the activation of the recurringly activated word line ACT. By doing so, and for the memory size as illustrated in the figure it would take 7 activation requests to refresh all the memory cells, not comprised in the recurringly activated row ACT.

However, it is also possible to refresh only the memory cells comprised in the directly adjacent rows (above or below the activated row as illustrated) alternating, as they have the highest probability for data integrity issues. However, this may lead to further data integrity issues, as only the same memory cells of the two rows are refreshed. Finally, and what is the most preferable logic, is that the memory cells comprised in rows that have a higher probability for data integrity issues will be refreshed more often than memory cells comprised in rows that have a lower probability. This means that the memory cells comprised in the row directly adjacent to the recurringly activated row ACT may be refreshed every fourth time when the recurringly activated row is activated, whereas the memory cells in a different than the directly adjacent rows are refreshed every sixth time upon the request for the activation for the recurringly activated row ACT. By taking the distribution into account, data integrity issues can be effectively prevented. The logic can be implemented in and being part of the control circuit, as illustrated in Fig. 7.

### Reference symbols in the figures

- ADDRESS: address (row and column) in the array of a memory cell
- ACT: activation of a word line of a row, recuring activation
- BD: Bit data
- B_{L1}, B_{L2}, B_{LN}: bit lines
- B_{L1*}, B_{L2*}: connectable bit lines
- CAB: column address buffer
- CAST: column address strobe
- CMD: column multiplexer /demultiplexer, read-write or row buffer
- DB: data buffer
- DP: data port
- C₁₁, C₁₂, C_{NM}: memory cell
- G: transmission gate enable
- Gₐ: transmission gate circuit
- GND: ground, ground supply
- o1, o2: signal ports
- Pᵣₑ: precharge circuit
- RAB: row address buffer
- RAD: row address decoder
- RAST: row address strobe
- Ro, R_{D-1}, R_{D+1}: probability for data integrity threat or issues
- S, S#: sense amplifier enable (incl. invert port)
- Sₐ: sense amplifier
- Sₐₚ, Sₐₚ₁: sense amplifier, first sense amplifier
- Sₐₛ, Sₐₛ₁: second sense amplifier
- S1-S3: method step
- TC: timing and control circuit, control circuit
- W_{L1}, W_{L2}, W_{LN}: word line
- Vdd: supply voltage (high)
- V_{subscript}: voltage apparent at an input, output, or enable port

## Claims

1. Integrated dynamic random access memory (DRAM) circuit comprising:
- bit lines (B_{L1}, B_{L2}, B_{LN}) and word lines (W_{L1}, W_{L2}, W_{LN});
- memory cells (C₁₁, C₁₂, CNM), each memory cell (C₁₁, C₁₂, C_{NM}) being connected to one bit line (B_{L1}, B_{L2}, B_{LN}) and one word line (W_{L1}, W_{L2}, W_{LN}) via terminals of a cell transistor and configured to store one bit in the form of an electric charge;
- a first sense amplifier (Sₐₚ) and a precharge circuit (Pᵣₑ) connected in parallel via two bit lines (B_{L1}, B_{L2});
- a second sense amplifier (Sₐₛ);
- a transmission gate circuit (Gₐ₁) connected in parallel to the first sense amplifier (Sₐₚ) via the same two bit lines (B_{L1}, B_{L2}) and being connected to the second sense amplifier (Sₐₛ), wherein the transmission gate circuit (Gₐ₁) being configured to connect the second sense amplifier (Sₐₛ) to and disconnect the second sense amplifier (Sₐₛ) from the two bit lines (B_{L1}, B_{L2}) to which the transmission gate circuit (Gₐ₁) is connected for establishing or interrupting a parallel connection of the first sense amplifier (Sₐₚ) and the second sense amplifier (Sₐₛ).

2. The integrated DRAM circuit of claim 1, wherein first sense amplifier (Sₐₚ) and the second sense amplifier (Sₐₛ) are configurated to be activated for sensing, amplifying and latching a potential difference between the two bit lines (B_{L1}, B_{L2}) and being configured to be deactivated.

3. The integrated DRAM circuit of claim 1 or 2, wherein the precharge circuit (Pᵣₑ) is configured to be activated for electrically charging the two bit lines (B_{L1}, B_{L2}) and configured to be deactivated.

4. The integrated DRAM circuit of any one of the claims 1 to 3, wherein one terminal, preferably a gate, of each cell transistor being connected to one word line (W_{L1}, W_{L2}, W_{LN}) and configured to activate and deactivate the corresponding word line, for selecting or deselecting a corresponding memory cell (C₁₁, C₁₂, C_{NM}).

5. The integrated DRAM circuit of the claim 4, comprising a control circuit (TC) configured to selectively activate and deactivate the cell transistors, the first and second sense amplifier (Sₐₚ, Sₐₛ), the transmission gate circuit (Gₐ₁), and the precharge circuit (Pᵣₑ).

6. The integrated DRAM circuit of any one of the claims 1 to 5, wherein the second sense amplifier (Sₐₛ) being connected to a pair of secondary bit lines (B_{L1*}, B_{L2*}) for providing data to or receiving data from a column selector, connected to the pair of secondary bit lines (B_{L1*}, B_{L2*}).

7. The integrated DRAM circuit of any one of the claims 1 to 6, comprising:
- a plurality of bit lines (B_{L1}, B_{L2}, B_{LN}), a plurality of word lines (W_{L1}, W_{L2}, W_{LN}), and a plurality of memory cells, each being connected to one bit line (B_{L1}, B_{L2}) and one word line (W_{L1}, W_{L2}) and arranged in an array structure having multiple rows and columns;
- a plurality of precharge circuits (Pᵣₑ), first sense amplifiers (Sₐₚ), second sense amplifiers (Sₐₛ), and transmission gate circuits (Gₐ₁),
wherein each column of the array structure comprises one first sense amplifier (Sₐₚ), one precharge circuit (Pᵣₑ), one transmission gate circuit (Gₐ₁), and one second sense amplifier (Sₐₛ), wherein each one of the second sense amplifiers (Sₐₛ) being connectable to two bit lines (B_{L1}, B_{L2}, B_{LN}) of a column through the transmission gate circuit (Gₐ₁).

8. DRAM module, comprising a plurality of DRAM chips, wherein each DRAM chip comprises a plurality of banks with a plurality of subarrays, wherein each subarray comprises the integrated DRAM circuit of any one of the claims 1 to 7.

9. Method for refreshing memory cells (C₁₁, C₁₂, C_{NM}) connected to a second word line (W_{L2}) while processing an activation request for a first word line (W_{L1}), wherein the memory cells (C₁₁, C₁₂, C_{NM}) and the word lines (W_{L1}, W_{L2}) being comprised in the integrated DRAM circuit of any one of the claims 1 to 7, comprising the steps of:
- receiving a request for activation of the first word line (W_{L1}) from a memory controller external to the integrated DRAM circuit;
- activating the first word line (W_{L1}), the transmission gate circuit (Gₐ₁), and the second sense amplifier (Sₐₛ) for latching the bit stored in the memory cell (C₁₁) connected to the first word line (W_{L1}) into the second sense amplifier (Sₐₛ);
- deactivating the first word line (W_{L1}) and the transmission gate circuit (Gₐ₁);
- precharging the bit lines (B_{L1}, B_{L2}, B_{LN}) by sequentially activating and deactivating the precharge circuit (Pᵣₑ);
- activating the second word line (W_{L2}) being different from the first word line (W_{L1}), and the first sense amplifier (Sₐₚ) for latching the bit stored in the memory cell (C₁₂) connected to the second word line (W_{L2}) into the first sense amplifier (Sₐₚ);
- sequentially deactivating the second word line (W_{L2}) and the first sense amplifier (Sₐₚ) for storing the bit latched in the first sense amplifier (Sₐₚ) into the corresponding memory cell (C₁₂);
- activating the first word line (W_{L1}), the transmission gate circuit (Ga1); and
- sequentially deactivating the first word line (W_{L1}), the transmission gate circuit (Gₐ₁) and the second sense amplifier (Sₐₛ) for storing the bit latched in the second sense amplifier (Sₐₛ) into the corresponding memory cell (C₁₁).

10. Method for refreshing memory cells (C₁₁, C₁₂, C_{NM}) of claim 9, further comprising the step of precharging the bit lines (B_{L1}, B_{L2}, B_{LN}) by sequentially activating and deactivating the precharge circuit (Pᵣₑ) prior to the activation of one word line (W_{L1} W_{L2}).

11. Method for refreshing memory cells (C₁₁, C₁₂, C_{NM}) of claim 9 or 10, comprising the step of overwriting the bit latched in the second sense amplifier (Sₐₛ) for updating the memory cell (C₁₁) connected to the first word line (W_{L1}) with data received from a row buffer (CMD).

12. Method for refreshing memory cells (C₁₁, C₁₂, C_{NM}) of any one of the claims 9 to 11, wherein the steps are performed within one row active time (tRAS) in accordance with the JEDEC standard JESD79-4D or JESD79-5B respectively.

13. Method for refreshing memory cells (C₁₁, C₁₂, C_{NM}) of claim 12, wherein the method is used alternatively or in addition to refresh operations as defined in the said standard.

14. Method for preventing a data integrity attack in an integrated DRAM circuit of claim 7 or in a DRAM module of claim 8:
- identifying a request for activation of the first word line (W_{L1});
- refreshing memory cells (C₁₁, C₁₂, C_{NM}) connected to a different than the first word line (W_{L1}) by sequentially applying the method for refreshing memory cells of any one of the claims 9 to 13.

15. Method of claim 14, wherein the different than the first word line (W_{L2}, W_{LN}), being a word line (W_{L2}, W_{LN}) comprised in a row directly adjacent to the row of the first word line (W_{L1}) or being selected for refreshing memory cells (C₁₁, C₁₂, C_{NM}) based on a probability for an integrity threat to memory cells (C₁₁, C₁₂, C_{NM}) connected to the said different word line (W_{L2}, W_{LN}), due to an activation of the first word line (W_{L1}).
